# FASCICULE DE BREVET EUROPEEN

(11) **EP 1 346 402 B1**
(45) Date de publication et mention de la délivrance du brevet: **01.10.2008**
(21) Numéro de dépôt: 01995751.3
(22) Date de dépôt: 27.12.2001
(51) Int. Cl.: H01L 21/18, H01L 21/762

(54) **PROCEDE DE REALISATION D'UNE STRUCTURE EMPILEE**
VERFAHREN ZUR HERSTELLUNG EINER STAPELSTRUKTUR
METHOD FOR PRODUCING A STACKED STRUCTURE

(30) Priorité: 28.12.2000 FR 0017215
(43) Date de publication de la demande: 24.09.2003
(73) Titulaire: COMMISSARIAT A L'ENERGIE ATOMIQUE, 75015 Paris (FR)
(72) Inventeur: FOURNEL, Franck, F-38430 MOIRANS (FR); MORICEAU, Hubert, F-38120 SAINT-EGREVE (FR); ZUSSY, Marc, F-38000 GRENOBLE (FR); MAGNEA, Noël, F-38430 MOIRANS (FR)
(74) Mandataire: Poulin, Gérard
(86) Numéro de dépôt international: PCT/FR2001/004130
(87) Numéro de publication internationale: WO 2002/054466

(56) Documents cités:
- EP-A- 0 460 437
- US-A- 5 783 477
- US-A- 6 010 579
- CHOU Y-F ET AL: "ANGULAR ALIGNMENT FOR WAFER BONDING" PROCEEDINGS OF THE SPIE, SPIE, BELLINGHAM, VA, US, vol. 2879, 14 octobre 1996 (1996-10-14), pages 291-297, XP001011387 cité dans la demande

## Description

### DOMAINE TECHNIQUE

La présente invention est relative à un procédé de réalisation d'une structure empilée à partir de structures à assembler comprenant chacune au moins une partie cristalline. L'invention s'applique notamment dans le domaine de la microélectronique, de l'optique, de l'optoélectronique.

Généralement, on s'intéresse à des structures dont la partie cristalline est en matériau semi-conducteur et en particulier en silicium, en Si₁₋ₓGeₓ, en carbure de silicium, en germanium, en nitrure de gallium, en phosphure d'indium, en arséniure de gallium ou tous autres composés III-V, II-VI, IV-IV. On peut aussi s'intéresser à des matériaux supraconducteurs, à des matériaux diélectriques tels que le diamant. Ces matériaux sont pris seuls ou en combinaison.

### ETAT DE LA TECHNIQUE ANTERIEURE

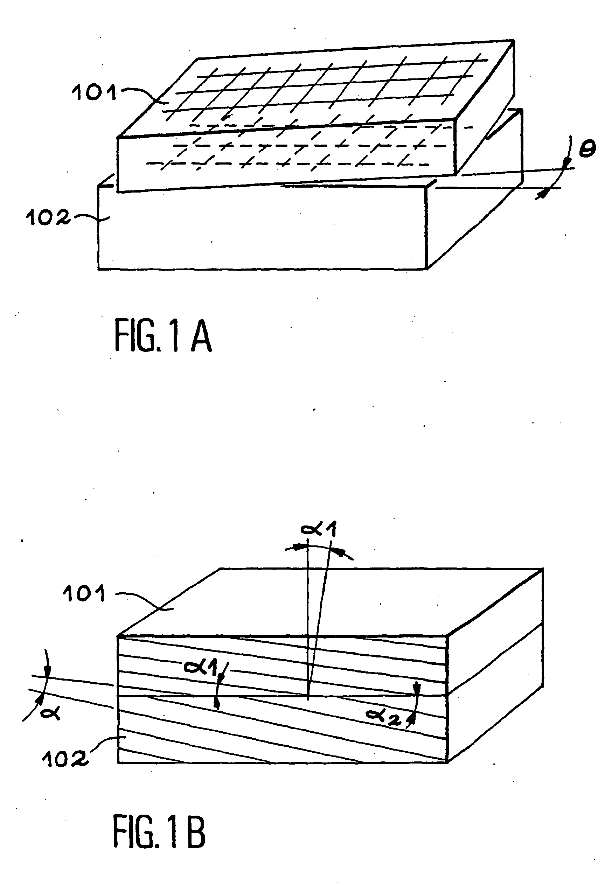

L'assemblage de plaquettes réalisées en matériaux semiconducteurs est une étape classique et connue en électronique. On peut se référer par exemple au brevet américain US-5 661 316 de Kish Jr et al qui propose de réaliser une jonction ohmique entre les deux plaquettes 101, 102. On se réfère aux figures 1A, 1B.

Les faces des plaquettes à assembler présentent généralement un angle d'inclinaison respectivement α₁, α₂ par rapport à un plan cristallographique de surface. Dans ce brevet américain on cherche à réduire au maximum, dans le plan de l'interface, l'angle de décalage en rotation θ entre les deux réseaux cristallins présentés par les faces à assembler et l'angle d'inclinaison résultant α qui est l'angle existant entre les plans cristallographiques des faces des plaquettes une fois mises en contact.

L'angle de décalage en rotation θ est mis en évidence sur la figure 1A. L'angle d'inclinaison résultant α est mis en évidence sur la figure 1B. Les traces des plans cristallographiques sont schématisées par la série de lignes parallèles sur la figure 1B. L'angle de décalage en rotation θ est connu sous la dénomination anglo-saxonne d'angle de «twist», tandis que les angles d'inclinaison α₁, α₂ sont connus sous la dénomination anglo-saxonne d'angles de «tilt». L'angle d'inclinaison α existant entre les plans cristallographiques des deux faces des plaquettes 1, 2 une fois mises en contact dépend des angles de tilt α₁, α₂ et de l'angle de twist θ.

Dans la suite de la description, le terme angle de décalage en rotation désignera l'angle de twist, le terme angle d'inclinaison désignera l'angle d'inclinaison d'une face par rapport aux plans cristallographiques de cette même face et le terme angle d'inclinaison résultant l'angle existant entre les plans cristallographiques de l'interface des deux plaquettes ou structures assemblées l'une à l'autre.

Dans la demande de brevet WO 99/05711 au nom du Commissariat à l'Energie Atomique, pour réaliser des microstructures ou des nanostructures auto-organisées, on cherche à ce qu'à l'interface entre les deux plaquettes, on soit en présence d'au moins un désaccord cristallographique très bien contrôlé de manière à former un réseau de défauts cristallins et/ou un réseau de contraintes au sein d'une zone cristalline s'étendant de chaque côté de l'interface. Pour cela on cherche à être en présence à l'interface d'un angle de décalage en rotation θ et/ou d'un angle d'inclinaison résultant α bien prédéterminés.

Dans les deux cas, lorsqu'on veut réaliser de tels assemblages, on a besoin de contrôler avec une grande précision, à l'interface entre les deux structures à assembler, l'angle de décalage en rotation et/ou l'angle d'inclinaison résultant ainsi définis.

Actuellement pour contrôler à l'interface entre deux structures, l'angle d'inclinaison résultant, on choisit des structures dont on connaît l'angle d'inclinaison. Cet angle peut se mesurer par exemple par rayons X.

On peut également par des méthodes de polissage non homogène ou d'enlèvement local de matière imposer un angle d'inclinaison à chaque structure. Si on connaît l'angle d'inclinaison de plusieurs structures, on peut effectuer un tri de manière à apparier des structures qui donneront un angle d'inclinaison résultant de valeur appropriée. La méthode de tri nécessite d'avoir à disposition une multitude de structures à assembler surtout si une grande précision de l'angle d'inclinaison résultant est recherchée.

Mais dans tous les cas, la valeur de l'angle d'inclinaison et sa direction par rapport aux axes cristallins qui définissent l'angle de rotation doivent être connus pour chacune des structures avant l'assemblage. Ces méthodes sont très lourdes à mettre en oeuvre et sont consommatrices de temps.

De plus, si les angles d'inclinaison des faces à assembler deux structures ne sont pas rigoureusement identiques, ce qui est difficile à obtenir, il n'est pas possible que l'assemblage conduise à un angle d'inclinaison résultant quasi nul puisque c'est au minimum environ la différence entre les angles d'inclinaison des deux faces à assembler.

Pour contrôler l'angle de décalage en rotation, on peut munir les structures à assembler de méplats et utiliser ces méplats lors de l'assemblage comme le montre le brevet US-5 661 316 déjà cité. Mais la difficulté réside dans le fait de connaître l'orientation cristallographique du méplat sur chacun des structures. Donc, il faut déterminer au moins un axe du réseau cristallin de chacune des structures. Une méthode de détermination de l'axe cristallin peut se faire par rayons X mais plus la structure est mince moins la précision de la détermination est bonne. Avec un film cristallin dont l'épaisseur est de l'ordre de 200 nanomètres, la précision de détermination d'un axe cristallin par les rayons X ne peut atteindre facilement le centième de degré.

Dans la demande de brevet EP 0 460 437, il est proposé de réaliser un substrat SOI (silicium sur isolant) à partir de deux disques semi-conducteurs prélevés dans une même structure initiale. Les faces à assembler des disques sont applanies au préalable. Lors de l'assemblage, les deux disques sont alignés en rotation grâce a la présence de marques de repérage.

L'article « Angular alignment for wafer bonding » de Yuang-Fang CHOU et Ming-Hsun HSIEH paru dans Proceedings SPIE, The International Society for Optical Engineering, Micromachining and Microfabrication Process Technology II, Vol2879, 1996, pages 291 à 299 propose une méthode de détermination de l'angle de décalage en rotation entre les réseaux cristallins de deux plaquettes à assembler. Il s'agit d'une méthode de gravure chimique anisotrope effectuée sur chacune des plaquettes avant leur assemblage. Elle permet de révéler leurs directions cristallines mais la difficulté consiste à contrôler l'angle de décalage en rotation de leurs réseaux cristallins lors de l'assemblage de manière à obtenir une grande précision. Par ailleurs, il n'est pas enseigné le contrôle de l'angle de tilt des plaquettes.

### EXPOSÉ DE L'INVENTION

La présente invention a pour but de proposer un procédé de réalisation d'une structure empilée qui ne présente pas les inconvénients de l'art antérieur. La structure empilée obtenu par le procédé de l'invention possède un angle de décalage en rotation entre les réseaux cristallins des deux parties cristallines des structures à assembler et un angle d'inclinaison résultant aisément maîtrisables, et ce avec une grande précision qui peut atteindre le centième de degré.

Pour y parvenir, le procédé selon l'invention est un procédé de réalisation d'une structure empilée à partir de structures à assembler pour former l'empilement, tel que défini dans la revendication 1.

Il est avantageux que la différence entre les angles d'inclinaison des deux faces créées des deux parties cristallines soit sensiblement nulle, c'est à dire que les angles d'inclinaison des deux faces créées des deux parties cristallines sont sensiblement égaux, cela permet notamment d'obtenir un angle d'inclinaison résultant sensiblement nul.

Les structures à assembler peuvent bien entendu être entièrement dans un même matériau cristallin et dans ce cas l'étape de formation des structures à assembler est réalisée en même temps que l'étape d'obtention des parties cristallines.

Par contre, les structures à assembler peuvent comporter respectivement une partie cristalline sur un support, la partie cristalline pouvant être même recouverte d'une couche non cristalline.

Dans ce dernier cas de figure, plusieurs modes de réalisation des structures à assembler sont envisageables. En particulier la partie cristalline peut être associée à un support avant ou après le prélèvement dans la structure initiale. Par ailleurs chaque partie cristalline prélevée peut comporter un ou plusieurs matériaux cristallins empilés éventuellement associés à un ou plusieurs matériaux non cristallins.

On peut prévoir, avant l'assemblage et après prélèvement, au moins une étape de préparation de la face à assembler d'au moins une des structures, cette étape de préparation se faisant en contrôlant l'évolution de l'angle d'inclinaison de la dite face.

Cette étape de préparation peut être un polissage ou un lissage thermique de la face à assembler.

Cette étape de préparation peut être un amincissement de la structure de manière à mettre à jour un matériau cristallin enterré de la partie cristalline.

Cette étape de préparation peut être une étape de dépôt ou de croissance d'un matériau sur la face à assembler.

Le matériau peut être cristallin ou amorphe.

Cette étape de préparation peut être une combinaison de ces étapes.

On peut prévoir avant le prélèvement d'au moins une des parties cristallines, une étape de fixation de la partie cristalline sur une première poignée. Cette poignée est importante si la partie cristalline est mince.

On peut prévoir une étape de fixation de la partie cristalline sur une seconde poignée après son prélèvement de la structure initiale, puis une étape de retrait de la première poignée libérant la face à assembler. Les parties cristallines sont alors retournées par rapport à leurs positions avant prélèvement.

Avantageusement une étape d'implantation ionique peut être réalisée dans l'une au moins des structures et notamment dans l'une au moins des poignées ou à la jonction entre partie cristalline et poignée. Cette étape peut contribuer à l'élimination des poignées.

Le prélèvement peut être réalisé par des moyens mécaniques, optiques, chimiques, thermiques pris seuls ou en combinaison.

On peut aussi réaliser une étape d'implantation ionique au travers d'une face de la structure initiale pour obtenir une zone fragilisée, puis un traitement apte à provoquer la séparation d'une partie cristalline au niveau de la zone fragilisée. Ce traitement peut être un recuit thermique, une application de force mécanique ou une combinaison des deux.

L'étape d'assemblage peut se faire avec apport de matière ou sans apport de matière notamment par adhésion moléculaire.

Le contrôle des positions relatives des structures lors de l'assemblage peut comporter une étape de repérage d'au moins un axe cristallin d'au moins une des parties cristallines.

De manière plus simple, le contrôle des positions relatives des structures lors de l'assemblage peut être réalisé à l'aide d'au moins une marque de repérage portée par la structure initiale et se retrouvant sur les parties cristallines après prélèvement. Bien entendu ces marques peuvent se trouver dans les matériaux cristallins ou non de ces parties.

Un méplat ou un ou plusieurs ensembles de graduations peuvent faire office de marques de repérage.

On peut avant ou après le prélèvement reporter ces marques de repérage sur d'autres parties des structures à assembler et/ou de la structure initiale telles que leurs faces arrières, les poignées éventuelles.

Avantageusement, ces marques de repérage peuvent être gravées dans la structure initiale qui a subi au préalable une étape d'implantation ionique afin de créer une zone fragilisée, ladite gravure s'étendant au-delà de la zone fragilisée. Après la fixation d'une poignée sur la face implantée et un traitement apte à provoquer la séparation au niveau de la zone fragilisée, les marques de repérage se retrouvent sur les deux structures à assembler.

Pour obtenir un positionnement avec précision, le contrôle des positions relatives des structures lors de l'assemblage peut être réalisé en ajustant, la position d'au moins une marque de repérage de l'une des structures à assembler par rapport à la position d'au moins une marque de repérage d'une autre structure à assembler, par des moyens choisis parmi les moyens optiques, mécaniques, acoustiques, hydrodynamiques, ces moyens étant pris seuls ou en combinaison.

La présente invention concerne également une structure empilée, obtenue par le procédé ainsi exposé, à partir de structures à assembler composées en partie ou en totalité d'au moins un des matériaux choisis parmi les semi-conducteurs, les supraconducteurs, les matériaux diélectriques, les matériaux métalliques, les matériaux magnétiques, ces matériaux étant pris seuls, en combinaison et/ou en mélange.

Le procédé précédemment décrit peut être réitéré pour l'empilement de plusieurs structures à assembler dont les parties cristallines peuvent être prélevées dans une même structure initiale.

### BRÈVE DESCRIPTION DES DESSINS

L'invention sera mieux comprise et d'autres caractéristiques et avantages apparaîtront à la lecture de la description qui va suivre, donnée à titre purement illustratif et non limitatif, accompagnée des dessins annexés parmi lesquels :
- la figure 1A (déjà décrite) illustre l'angle de décalage en rotation θ existant entre les réseaux cristallins de deux plaquettes assemblées l'une à l'autre ;
- la figure 1B (déjà décrite) illustre les angles d'inclinaison α₁, α₂ formés entre les plans cristallographiques des faces à assembler des deux plaquettes et l'interface d'assemblage et l'angle d'inclinaison résultant α formé par les plans cristallographiques des faces, une fois mises en contact ;
- les figures 2A, 2B, 2C illustrent différentes étapes du procédé selon l'invention ;
- les figures 3A, 3B, 3C, 3D illustrent différentes étapes d'une première variante du procédé selon l'invention ;
- les figures 4A, 4B, 4C, 4D illustrent différentes étapes d'une seconde variante du procédé selon l'invention ;
- la figure 5 montre les variations typiques de l'angle d'inclinaison résultant α en fonction de l'angle de décalage en rotation θ lors de l'assemblage de deux structures ;
- les figures 6A et 6B illustrent des marques de repérage effectuées sur la structure initiale avant la séparation ainsi que les marques obtenues sur les structures à assembler obtenues par prélèvement dans la structure initiale ;
- la figure 7 illustre deux structures équipées d'un méplat assemblées l'une à l'autre ;
- la figure 8A montre plusieurs ensembles de graduations assimilables à des rapporteurs, portés par une structure initiale ;
- la figure 8B montre de manière agrandie un détail d'un rapporteur de la figure 8A ;
- les figures 9A à 9E illustrent différentes étapes d'une autre variante du procédé selon l'invention.

### EXPOSÉ DÉTAILLÉ DE MODES DE RÉALISATION PARTICULIERS

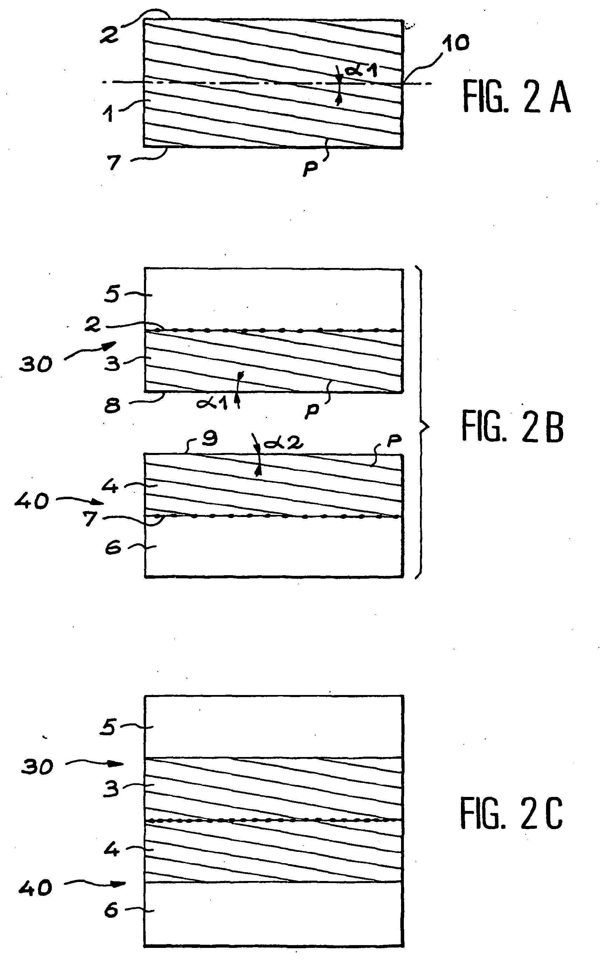

On se réfère aux figures 2. Sur la figure 2A est représentée une structure cristalline 1 initiale. Les traces d'un plan cristallographique p, dit de référence, de cette structure initiale 1 sont schématisées par les lignes parallèles inclinées. La ligne en pointillés indique un plan de découpe à effectuer pour obtenir deux parties cristallines 3, 4 devant servir pour former deux structures à assembler en les empilant l'une sur l'autre de manière à obtenir la structure empilée objet de l'invention. Un angle d'inclinaison α₁ existe entre le plan cristallographique de référence p de la structure initiale 1 et le plan de coupe. Les parties cristallines 3, 4 ont une face créée par la découpe référencée respectivement 8, 9 et ces faces créées 8, 9 présentent un angle d'inclinaison α₁, α₂ par rapport au plan cristallographique de référence p. Dans l'exemple décrit comme on a réalisé un seul plan de coupe les angles d'inclinaison α₁, α₂ sont sensiblement égaux et égaux à α₁.

Dans l'exemple décrit de la figure 2B, on suppose que les parties cristallines prélevées 3, 4, fixées chacune sur un support 5, 6 mono ou multicouche, forment les structures à assembler 30, 40. On pourrait découper plus de deux parties cristallines 3, 4 dans la structure initiale 1 et empiler plus de deux structures à assembler les unes sur les autres. On pourrait ainsi obtenir une structure empilée épaisse à partir d'une pluralité de parties cristallines minces. Cet empilage de structures à assembler peut être déposé sur un support quelconque.

On pourrait aussi coller deux à deux les parties cristallines 3,4 et ainsi obtenir une pluralité de structures assemblées 30, 40 à partir d'une même structure initiale 1.

La structure initiale 1 peut être réalisée en totalité dans un ou plusieurs matériaux cristallins ou être composite à base de matériaux cristallins et non cristallins.

La séparation peut se faire à l'interface entre deux matériaux différents ou à l'intérieur d'un même matériau.

Les matériaux cristallins peuvent être semi-conducteurs, supraconducteurs, diélectriques, métalliques ou magnétiques.

Comme matériaux semi-conducteurs, on peut utiliser le silicium, le Si₁₋ₓGeₓ, le carbure de silicium, le germanium, le nitrure de gallium, le phosphure d'indium, l'arséniure de gallium ou plus généralement tous composés III-V, II-VI, IV-IV. On peut aussi utiliser comme matériau diélectrique le diamant, comme matériaux métalliques le cuivre, le fer, le platine, le palladium, comme matériaux magnétiques le cuivre, le fer, les alliages CrCo, FeNi, FeAlSi, FeNiAg, le grenat ((Terre rare)₃ Fe₅₋ₓ Métalₓ O₁₂), comme matériaux supraconducteurs le YbaCuO, le NbN. Tous ces matériaux peuvent être pris seuls, en combinaison et/ou en mélange. Comme matériaux non cristallins, on peut utiliser des polymères, le SiO₂, le Si₃N₄.

Dans la structure initiale 1 on va commencer par prélever au moins deux parties cristallines 3, 4 à partir desquelles les structures 30, 40 à assembler vont être obtenues.

Les deux surfaces créées 8, 9 des deux parties cristallines prélevées 3, 4 présentent chacune un angle d'inclinaison α₁, α₂ respectivement par rapport au plan cristallographique de référence et ces angles d'inclinaison peuvent être égaux ou différents. Ils peuvent être connus ou non. Par contre, ce que l'on détermine, c'est la différence entre les dits angles d'inclinaison.

La découpe peut se faire avec des moyens mécaniques, avec une scie ou un jet d'eau par exemple, par des moyens ultrasonores, des moyens optiques avec un laser par exemple, des moyens chimiques ou thermiques ou selon le procédé décrit dans la demande de brevet FR-A-2 681 472. Ces moyens peuvent être utilisés seuls ou en combinaison.

Les moyens ultrasonores peuvent comporter un outil qui est entraîné en vibration par un transducteur ultrasonique. L'outil vibrant est mis en contact avec la structure initiale 1 dans laquelle on veut prélever les parties cristallines 3, 4 et il pénètre dans le matériau selon une direction déterminée. On peut intercaler des particules d'abrasif entre l'outil vibrant et la structure initiale ce qui facilite l'abrasion, cette dernière ne se produisant qu'entre l'outil et le matériau de la structure initiale 1. La forme de l'outil va définir la forme de l'usinage effectué. En donnant à l'outil une forme telle que sa section soit trapézoïdale, avec deux faces formant un angle de valeur déterminée, de quelques dixièmes de degrés par exemple, la différence d'angle d'inclinaison des deux faces obtenues par la découpe sera sensiblement égale à ladite valeur déterminée. Les angles d'inclinaison des faces créées seront différents.

Selon la demande de brevet FR-A- 2 681 472 qui permet la séparation par fracture de films minces, on implante des ions, des protons par exemple, au travers d'une face 2 de la structure initiale 1, pour obtenir une zone fragilisée 10, schématisée par les pointillés, à une profondeur déterminée par rapport à la face 2 implantée. Ladite face 2 implantée est ensuite par exemple fixée à une poignée 5 visant à faciliter la manipulation de la partie cristalline 3 qui va être ultérieurement prélevée. Cette poignée 5 peut avoir également un rôle de raidisseur de la partie cristalline lors de la séparation. La poignée peut être réalisée dans un au moins des matériaux de la liste citée plus haut.

Les moyens de fixation de la poignée 5 peuvent être un collage avec une substance adhésive, une substance provenant d'un dépôt par un procédé physique ou chimique tel que l'évaporation, la pulvérisation le dépôt chimique en phase vapeur, par exemple ou un collage par adhérence moléculaire. Les moyens de fixation peuvent être utilisés seuls ou en combinaison. En particulier, un traitement thermique peut être utilisé pour adapter l'efficacité de la fixation. Cette étape n'est pas représentée. Une étape de nettoyage chimique des faces à coller est généralement prévue avant une fixation par adhérence moléculaire.

Un traitement mécanique et/ou un traitement de recuit thermique peuvent être ensuite appliqués. Ils ont pour but de séparer en deux parties 3, 4, au niveau de la zone fragilisée 10, la structure initiale 1. Les faces créées par la séparation portent la référence 8 pour la partie cristalline 3 et la référence 9 pour la partie cristalline 4. Avec un tel procédé de découpe, les angles d'inclinaison par rapport au plan cristallographique de référence que présentent les deux faces crées 8, 9 des parties cristallines 3, 4 sont sensiblement égaux. Ils sont sensiblement égaux à l'angle d'inclinaison par rapport au même plan cristallographique de référence que possède la face 2 implantée. C'est pourquoi, par la suite on pourra assembler indifféremment les faces 8, 9 ou 2.

On peut envisager que la structure initiale 1 possède une autre face 7 tenue par une poignée 6 avant la séparation. Cette deuxième poignée 6 pourra être fixée par l'une des méthodes préconisées plus haut. Cette caractéristique n'est pas représentée sur la figure 2A mais les deux poignées sont visibles sur la figure 2B.

Si les poignées 5, 6 doivent être ôtées après obtention de la structure empilée, on choisira leur matériau et leur mode de fixation en conséquence. Par exemple une poignée en oxyde de silicium peut être éliminée dans un bain d'acide fluorhydrique. On pourrait les éliminer par un des moyens de séparation des parties.cristallines décrits précédemment.

Dans l'exemple décrit, les parties cristallines 3, 4 fixées chacune à une poignée 5, 6 forment les structures 30, 40 à assembler. Les deux structures obtenues 30, 40 vont être assemblées l'une à l'autre par leurs faces créées 8, 9 en contrôlant les positions relatives des structures 30, 40, en rotation dans le plan de l'interface, par rapport aux positions relatives des parties cristallines 3, 4 au sein de la structure initiale 1 de manière à obtenir un angle d'inclinaison résultant contrôlé à l'interface entre les deux structures 30, 40. La référence est donnée par les positions relatives des parties cristallines avant la séparation.

Sur la figure 2C qui illustre l'assemblage des deux structures 30, 40, on suppose que les deux parties cristallines 3, 4 conservent les mêmes positions relatives en rotation avant la séparation et lors de l'assemblage.

Cette configuration sans décalage en rotation permet de rendre nul ou quasi nul l'angle d'inclinaison résultant entre les plans cristallographiques de même indice de l'interface, des deux structures. En effet, les angles d'inclinaison des deux faces à assembler sont sensiblement égaux si la séparation est induite suivant un seul plan de coupe dans la structure initiale.

Si l'assemblage des structures conduit à un assemblage des parties cristallines prélevées telles quelles sans préparation de surface, avec un angle de décalage en rotation dans le plan de l'interface nul ou quasi nul, l'angle d'inclinaison résultant sera nul ou quasi nul.

Il est alors possible de minimiser ou de contrôler l'angle d'inclinaison résultant sans avoir à connaître l'angle d'inclinaison de chacune des structures.

En outre, on peut introduire une variation d'angle d'inclinaison volontaire très bien contrôlée, par exemple par un polissage mécanochimique (CMP), sur au moins une des structures à assembler. On peut ainsi contrôler l'angle d'inclinaison résultant sans pour autant avoir besoin de connaître les angles d'inclinaison des deux structures à assembler. On maîtrise alors l'angle d'inclinaison que possède la face à assembler de la structure traitée par rapport à l'angle d'inclinaison de la face créée de la partie cristalline prélevée correspondante.

L'assemblage des deux structures 30,40 peut être un scellement avec ou sans apport de matière à l'interface entre les deux structures 30, 40. S'il y a apport de matière pour réaliser la jonction, cette dernière peut avoir disparu ou non à l'issu de l'assemblage. Un type d'assemblage avantageux est connu sous la dénomination de collage moléculaire. Ce collage moléculaire peut être par exemple, de type hydrophobe, hydrophile, anodique, eutectique ou métallique. Pour un collage moléculaire hydrophobe, les deux surfaces 8, 9 à assembler reçoivent un traitement pour les rendre hydrophobes. Ce traitement peut comprendre une étape de nettoyage chimique se terminant par exemple par une étape d'attaque à l'acide fluorhydrique. On effectue ensuite une mise en contact des faces 8, 9 ainsi traitées, à température ambiante, en contrôlant les positions relatives des deux structures 30, 40 en rotation dans le plan de l'interface, par rapport aux positions relatives des parties cristallines 3, 4 respectives. La référence est la position des parties cristallines avant prélèvement. Cette mise en contact est illustrée à la figure 2C.

Les deux structures 30, 40 sont ensuite soumises à un traitement thermique de manière à favoriser les liaisons interatomiques à l'interface.

En outre, les deux structures 30, 40 à assembler peuvent être soumises à un ou plusieurs traitements de surface ou attaque de surface avant d'effectuer l'assemblage.

Par exemple, après la séparation, les surfaces séparées possèdent des micro-rugosités qui peuvent être atténuées par un polissage mécanique, chimique ou mécanochimique ou un traitement thermique lissant, à haute température, dans différentes atmosphères, par exemple, pour le lissage de surface de silicium, sous hydrogène, sous argon, sous azote ou sous vide. Le traitement peut ne pas modifier l'angle d'inclinaison de la structure par rapport à celui de la partie cristalline prélevée mais s'il le modifie, cette modification d'angle d'inclinaison est quantifiée de manière à pouvoir obtenir un angle d'inclinaison résultant contrôlé à l'interface entre les deux structures lors de l'assemblage.

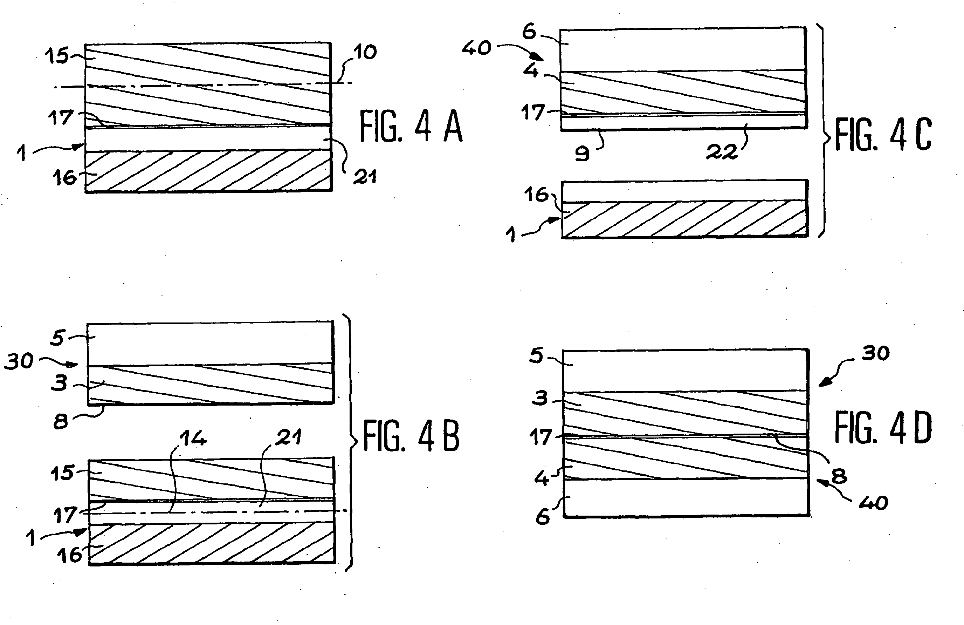

Chaque partie cristalline 3, 4 peut comporter plusieurs matériaux cristallins empilés éventuellement associés à un ou plusieurs matériaux non cristallins, comme on le verra lors de la description des figures 4. Dans ce cas, l'une au moins des structures à assembler est composée de plusieurs matériaux, il est possible de réaliser un amincissement, par exemple par attaque chimique et/ou ionique pour faire apparaître en surface un matériau cristallin qui serait encore enterré après séparation. C'est cette configuration qu'illustrent les figures 4 décrites ultérieurement. Une couche d'arrêt 17 de gravure est incluse dans l'une, l'autre ou les deux structures à assembler et l'amincissement est une attaque effectuée jusqu'à la couche d'arrêt 17.

On peut avantageusement réaliser au moins un dépôt ou la croissance d'au moins un matériau sur l'une au moins des surfaces séparées.

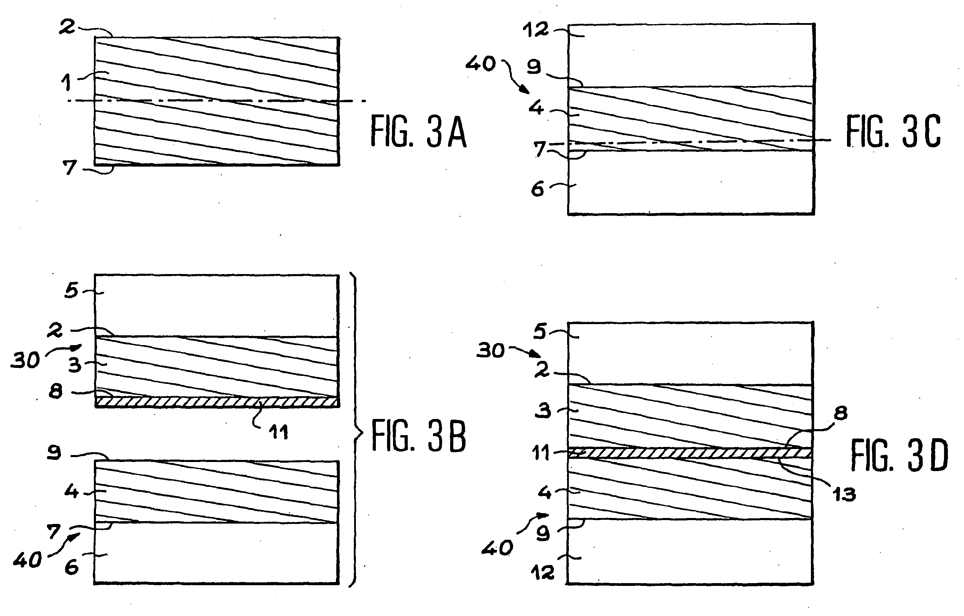

On suppose que cette variante est illustrée à la figure 3B décrite ultérieurement. La face séparée 8 de la partie cristalline 3 conduisant à la structure 30 est recouverte d'un matériau cristallin. La couche obtenue porte la référence 11. Avantageusement, le dépôt peut être fait par épitaxie.

Le matériau de la couche 11, au lieu d'être cristallin peut être amorphe. Ce peut être par exemple de l'oxyde de silicium, du nitrure de silicium, du verre, un polymère, par exemple une colle époxy. Ce matériau peut disparaître lors de traitements thermiques, chimiques ou mécaniques réalisés avant, pendant ou après l'assemblage. En conséquence, ce matériau peut être présent ou non à l'interface d'assemblage.

Les traitements de polissage, de croissance de dépôt, d'amincissement peuvent permettre d'imposer aux surfaces à assembler une variation d'angle d'inclinaison bien déterminée et donc peuvent permettre d'induire un angle d'inclinaison résultant relatif dont la valeur est volontairement choisie.

Les étapes de préparation de surface peuvent également ne changer que très peu les angles d'inclinaison des faces à assembler par rapport aux angles d'inclinaison des faces créées des parties cristallines. Par exemple, si on retire une épaisseur de 400 nanomètres à la surface d'une plaquette d'environ 10 centimètres de diamètre, la variation de l'angle d'inclinaison peut être inférieure au millième de degré, ce qui est considéré comme négligeable.

Avantageusement, une étape d'implantation ionique peut être réalisée avant la mise en contact des structures 30, 40 à assembler, au niveau de l'une au moins des poignées 5, 6 ou à l'interface entre la partie cristalline 3, 4 et la poignée correspondante 5, 6 ou dans la partie cristalline 3, 4. On suppose que sur la figure 2B une implantation ionique a été réalisée dans les structures à assembler 30, 40 à la jonction 2, 7 entre les poignées 5, 6 et les parties cristallines 3, 4, les zones fragilisées sont schématisées.

Cette implantation ionique peut être réalisée par de l'hydrogène, de l'hélium et/ou tout autre espèce gazeuse capable d'être implantée. Cette implantation induit en profondeur une zone fragilisée. Cette étape peut être mise à profit notamment pour séparer ultérieurement la poignée de la structure à laquelle elle est fixée. La séparation aura lieu au niveau de la zone fragilisée induite par l'implantation en appliquant, par exemple, le traitement thermique préconisé dans la demande de brevet FR-A-2 681 472.

Cette étape d'implantation ionique peut être réalisée avant la séparation des parties cristallines, avant l'assemblage des structures ou après.

On se réfère aux figures 3. On part d'une structure initiale 1 (figure 3A). On équipe chacune de ses faces d'une poignée respectivement 5, 6 et l'on sépare en deux parties la structure initiale 1 par implantation ionique à travers l'une des faces 7 et fracture. On obtient les deux structures 30, 40 à assembler. Elles comportent chacune une partie cristalline 3, 4 fixée sur une poignée 5, 6. Les parties cristallines 3, 4 comportent chacune une face séparée 8, 9 créée par la fracture. Ces faces 8, 9 présentent sensiblement le même angle d'inclinaison que la face 7 par laquelle a été réalisée l'implantation ionique. On fait subir à l'une des faces séparées 8 une croissance d'un matériau cristallin 11 (figure 3B). En ce qui concerne l'autre structure 40 obtenue après la séparation, on fixe sur sa face séparée 9 une seconde poignée 12 (figure 3C). On retire ensuite tout ou partie de la première poignée 6. Plusieurs possibilités de retrait peuvent être envisagées.

On peut réaliser un arrachement en exerçant sur la poignée 6 et la partie cristalline 4 des forces opposées. Une élimination par attaque chimique ou par abrasion mécanique peut être envisagée. Une combinaison de ces méthodes peut être employée.

L'abrasion peut aller au-delà de la poignée 6 et consommer une partie de la partie cristalline 4. Les pointillés de la figure 3C montrent où s'arrête l'abrasion. L'arrêt de l'abrasion peut avantageusement être provoqué par une couche d'arrêt. On suppose que sur la figure 3D une couche de matière de la structure 40 a été ôtée dans la partie cristalline 4 lors du retrait de la première poignée 6. Ce retrait a mis à jour une face cristalline 13 de la partie cristalline 4 de la structure 40 et c'est cette face 13 qui va être assemblée à la face traitée de l'autre structure 30.

On aurait pu envisager que ce retournement de structure à l'aide d'une paire de poignées soit réalisé sur les deux structures 30, 40. Au moins l'une des faces assemblées peut ne pas être l'une des faces obtenues par la séparation. Dans ce cas également on doit pouvoir suivre l'évolution de l'angle d'inclinaison de la face assemblée de la structure par rapport à celui de la face créée de la partie cristalline prélevée correspondante.

Les figures 4 illustrent le cas où plusieurs séparations sont réalisées dans la structure initiale 1. Sur la figure 4A, la structure initiale 1 est composite et formée de plusieurs couches 15, 16 cristallines, d'une couche amorphe 21 empilées les unes sur les autres, la couche amorphe 21 se trouvant entre les deux couches cristallines 15, 16. Dans cet exemple, les angles d'inclinaison des deux faces de la couche 15 doivent être égaux. C'est le cas, par exemple, si la structure initiale 1 est de type SOI (abréviation anglo-saxonne de semi-conducteur sur isolant). Une couche d'arrêt 17 peut être placée entre l'une des couches cristallines 15 et la couche amorphe 21.

On sépare de la structure initiale 1, par implantation ionique à travers la couche 15 et fracture selon le plan 10, une première partie cristalline 3, elle est représentée fixée à une poignée 5 sur la figure 4B et l'ensemble forme l'une des structures 30 à assembler. La face créée de la partie cristalline 3 est libre, elle porte la référence 8, c'est la face qui va être assemblée pour réaliser la structure empilée. Cette partie cristalline 3 est prélevée dans la couche cristalline 15.

On sépare ensuite, selon le plan 14 dans la masse de la structure initiale 1, une seconde partie cristalline 4 que l'on équipe au préalable également d'une poignée 6 (figure 4C). Cette seconde partie cristalline 4 comporte du matériau cristallin de la couche cristalline 15, elle est associée à la couche d'arrêt 17 et à du matériau amorphe 22 de la couche 21. L'ensemble poignée 6, partie cristalline 4, couche d'arrêt 17, matériau amorphe 22 forme la seconde structure 40. Cette seconde structure 40 comporte une face libre 9 qui correspond au matériau amorphe 22. On attaque cette face libre 9 jusqu'à tout ou partie de la couche d'arrêt 17 de manière à éliminer le matériau amorphe 22. Si la couche d'arrêt est absente, l'élimination du matériau amorphe 22 conduit à la mise à jour du matériau cristallin de la couche cristalline 15.

La face libre 9 ainsi traitée est assemblée à la face libre 8 de l'autre structure 30. Ce mode opératoire permet d'économiser la structure initiale 1 qui peut être réutilisée.

Lors de l'assemblage, si l'on provoque une rotation θ dans le plan de l'interface, de l'une des structures à assembler par rapport à l'autre, on fait en même temps tourner la direction de l'angle d'inclinaison de la face à assembler de la structure en rotation, par rapport à la normale à ladite face. Cela permet de moduler la valeur de l'angle d'inclinaison résultant α entre les deux structures. Un angle de rotation θ nul produira un angle d'inclinaison résultant α sensiblement égal à la différence, en valeur absolue, des angles d'inclinaison α₁, α₂ des faces à assembler, tandis qu'une rotation de 180° produira un angle d'inclinaison résultant α sensiblement égal à la somme des angles d'inclinaison des faces à assembler.

Si les deux structures à assembler possèdent le même angle d'inclinaison au niveau de leur face à assembler, c'est le cas par exemple si la séparation a été réalisée, avec le procédé décrit dans le brevet FR-A-2 681 472, selon l'angle de décalage en rotation, l'angle d'inclinaison résultant varie entre 0°, pour une rotation nulle, et deux fois l'angle d'inclinaison, pour une rotation de 180°. Par un tel procédé de séparation, l'angle d'inclinaison est sensiblement celui de la face implantée de la structure initiale.

Dans cette configuration de façon avantageuse, si on cherche à obtenir un angle d'inclinaison résultant nul, il n'est même pas nécessaire de connaître la valeur de l'angle d'inclinaison de la face implantée. En revanche, si on cherche une valeur prédéterminée de l'angle d'inclinaison résultant, seule la connaissance de la valeur de l'angle d'inclinaison de la face implantée peut être nécessaire, mais le repérage de sa direction importe peu. Ce n'était pas le cas antérieurement.

On peut ainsi obtenir un angle d'inclinaison résultant volontairement ajusté en jouant, pendant l'assemblage, sur l'angle de décalage en rotation des structures à assembler.

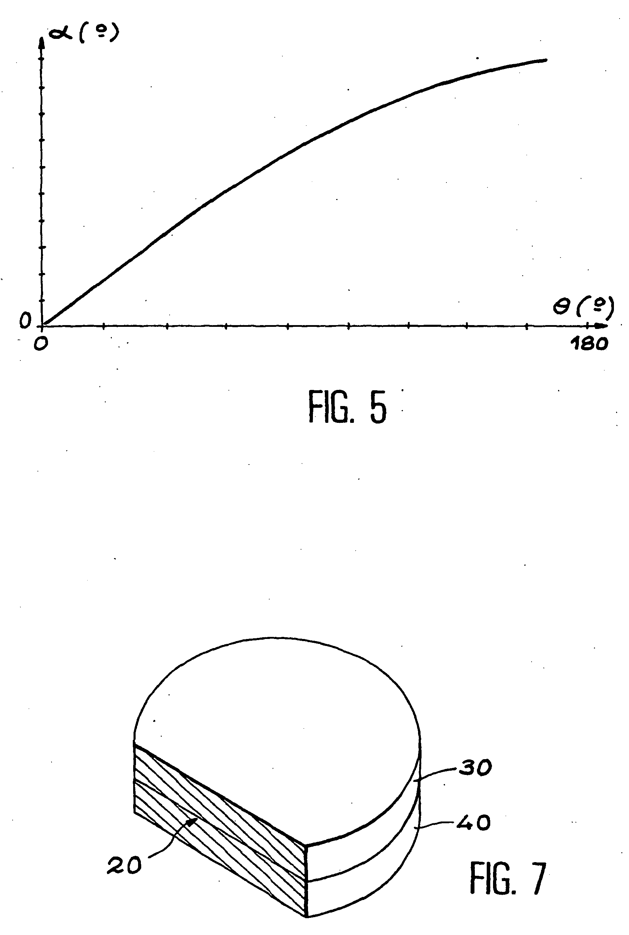

La figure 5 montre les variations typiques de l'angle d'inclinaison résultant α en fonction de l'angle de décalage en rotation θ des réseaux cristallins présentés par les faces assemblées.

Cependant, pour pouvoir maîtriser finement l'angle de décalage en rotation θ des réseaux cristallins présentés par les deux faces à assembler, il n'est pas nécessaire, comme auparavant, de connaître les directions cristallines des réseaux cristallins présentés par lesdites faces, il suffit de contrôler de manière précise les positions relatives en rotation des structures à assembler.

On peut, dans cette optique, avant l'étape de séparation, réaliser une ou plusieurs marques de repérage 18, 19 dans la structure initiale 1. Ces marques de repérage sont telles qu'on les retrouve dans les structures 30, 40 à assembler obtenues à partir des parties cristallines prélevées dans la structure initiale.

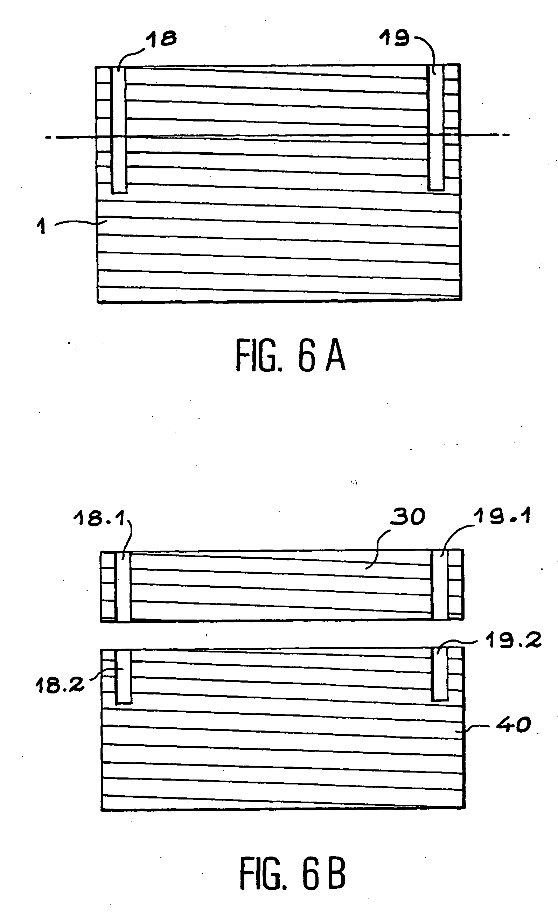

On se réfère aux figures 6A, 6B. La figure 6A illustre en coupe, la structure initiale 1 en forme de disque portant, avantageusement à proximité de son bord, deux marques 18, 19 de repérage avantageusement diamétralement opposées. Ces marques 18, 19 peuvent prendre, en surface, la forme de carrés de 5 micromètres de côté. Elles peuvent être espacées d'environ 8 centimètres si le diamètre de la structure en fait environ dix. Ces marques 18, 19 s'étendent suffisamment profond dans la structure initiale 1 de sorte qu'on les retrouve sur les deux structures 30, 40 à assembler obtenues à partir de la structure initiale 1. La figure 6B montre les deux structures 30, 40 à assembler une fois séparées ainsi que les marques de repérage qu'elles portent 18.1, 18.2, 19.1, 19.2. Ces marques de repérage sont des fractions des marques de repérage portées par la structure initiale 1. Sur la figure 6B aucune poignée n'a été représentée, mais il pourrait y en avoir notamment si les structures à assembler sont des films minces.

Ces marques de repérage 18, 19 peuvent ou non traverser de part en part la structure initiale 1, ce qui est important c'est que ces marques de repérage soient présentes sur les deux structures 30, 40 à assembler, et en particulier elles traversent totalement au moins une partie cristalline prélevée dans la structure initiale.

Ces marques de repérage 18, 19 peuvent être réalisées par une méthode de gravure prise parmi la gravure chimique, ionique, optique, par exemple à l'aide d'un faisceau laser, mécanique à travers ou non d'un masque réalisé en polymère par exemple, ou par une combinaison de ces méthodes.

Munies de ces marques de repérage 18.1, 18.2, 19.1, 19.2, les structures 30, 40 peuvent être assemblées en alignant les marques deux à deux ou au contraire en prévoyant un décalage contrôlé en rotation entre elles. Leur alignement permet de réaliser un assemblage avec un angle de décalage en rotation sensiblement nul.

Le positionnement peut se faire avantageusement de manière optique, par exemple par infrarouge, de manière mécanique, acoustique ou hydrodynamique ou par une combinaison de ces méthodes.

Si les marques de repérage sont réalisées dans une même structure cristalline initiale dans laquelle se fera un prélèvement ou dans des structures en relation cristalline ce qui est le cas avec le dépôt d'une couche par exemple par épitaxie, elles présentent un même désalignement par rapport aux directions cristallines présentées par les faces à assembler. On est sûr que si on aligne les marques de repérage, l'angle de décalage en rotation θ des réseaux cristallins présentés par les faces à assembler sera nul aux erreurs d'alignement près et ce avantageusement quelle que soit l'orientation initiale des marques de repérage. La recherche des directions des réseaux cristallins est superflue.

Par exemple si les deux structures à assembler portent des marques de repérage de 10 micromètres de large, séparées d'environ 10 centimètres, et que leur alignement deux à deux est réalisé, par exemple par infrarouge, sous microscope, il est possible d'obtenir un positionnement en rotation des deux structures possédant une précision de l'ordre du millième de degré.

Avantageusement ces marques de repérage consomment très peu de surface utile par rapport à celle consommée par une gravure chimique anisotrope utilisée pour révéler une direction cristalline.

Au lieu de réaliser des marques de repérage comme décrit aux figures 6, il est possible de munir la structure initiale, généralement en forme de disque, d'un méplat 20. Cette variante est illustrée à la figure 7 qui montre la structure empilée objet de l'invention. Elle est formée de deux structures à assembler 30, 40 provenant de la structure initiale.

Un tel méplat, traversant tout ou partie de la structure initiale, unique dans son repérage relatif aux structures à assembler, résout avantageusement le problème rencontré par l'usage des méplats fournis de façon commerciale et qui sont arrondis par les chanfreins de bord de plaque.

On obtient en final une structure dont l'angle de décalage en rotation et l'angle d'inclinaison résultant sont connus et choisis sans qu'à aucun moment dans l'élaboration de cette structure, on ait eu besoin de connaître la direction cristallographique de l'une ou l'autre des parties cristallines.

Toutefois, pour contrôler l'angle de décalage en rotation entre les structures à assembler, on pourrait aussi employer une méthode de révélation d'au moins un axe cristallin des réseaux cristallographiques présentés par les faces à assembler. On peut citer par exemple la gravure chimique, les rayons X, une révélation optique, acoustique ou toute autre méthode appropriée utilisant une anisotropie de propriété.

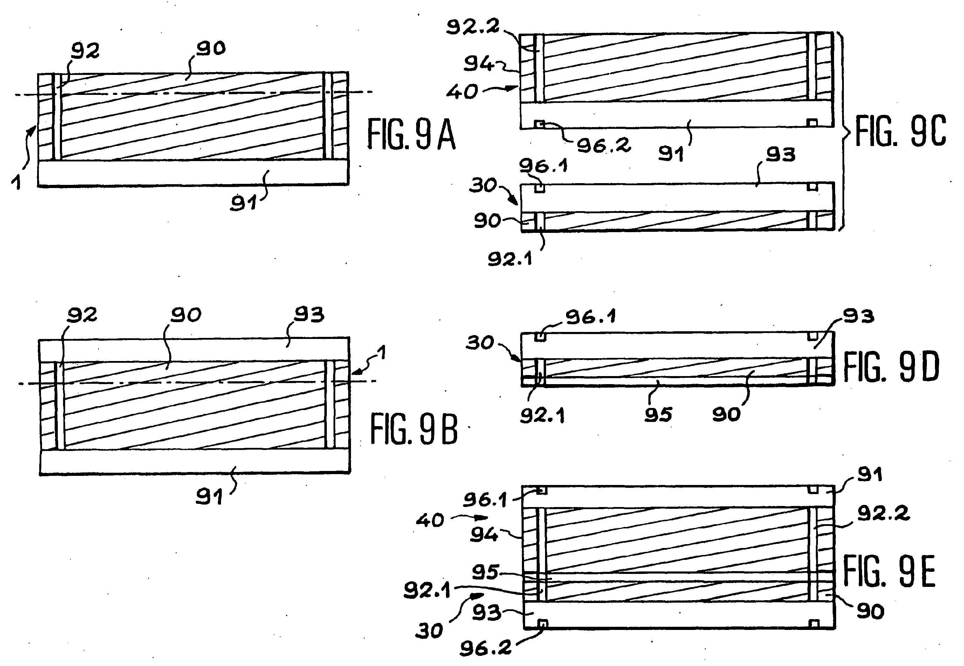

On va décrire maintenant deux exemples de réalisation d'une structure empilée obtenue par le procédé de l'invention. On se réfère aux figures 9.

On peut par exemple prélever un film 90 de Si₁₋ₓGeₓ avec x<1 dans une structure initiale 1 éventuellement supportée par un substrat 91. Pour cela on peut implanter de l'hydrogène, en quantité apte à permettre une séparation dans la structure initiale 1. Cette structure initiale 1 est équipée de marques de repérage 92 (figure 9A). On fixe le film 90 de Si₁₋ₓGeₓ sur un support 93 qui sert de poignée (figure 9B). Par traitement thermique par exemple, on effectue la séparation du film 90 de la structure initiale 1 (figure 9C). Ce film 90 va contribuer à former l'une des structures 30 à assembler. La référence 94 illustre la partie restante de la structure initiale 1 après la séparation du film 90. Cette partie restante va contribuer à former l'autre structure 40 à assembler.

Les marques de repérage se retrouvent sur les deux parties obtenues avec les références 92.1 sur le film 90 et 92.2 sur la partie restante 94 de la structure initiale.

Les marques de repérage 92 peuvent être reportées sur d'autres parties des structures 30, 40 à assembler. Sur la figure 9C, ces marques de repérage portent les références 96.1, 96.2 et elles sont reportées sur les faces arrières des structures 30, 40 à assembler au niveau des poignées 91, 93.

Après la séparation, on réalise un dépôt 95 par épitaxie de Si_{1-y}Ge_{y} sur le film séparé 90 tout en conservant les marques de repérage 92.1 (figure 9D). Si des marques de repérage 96.1 ont été reportées au niveau de la poignée 93, la conservation des marques de repérage 92.1 n'est pas nécessaire.

On peut ensuite coller le film épitaxié 95 sur la partie restante 94 de la structure initiale 1 en maîtrisant les positions relatives du reste 94 de la structure initiale 1 et du film prélevé 90, en rotation dans le plan de l'interface, par rapport aux positions relatives qu'ils possédaient avant le prélèvement (figure 9E) en se servant des marques de repérage 92.1, 92.2. On contrôle alors les réseaux de dislocations générés à l'interface.

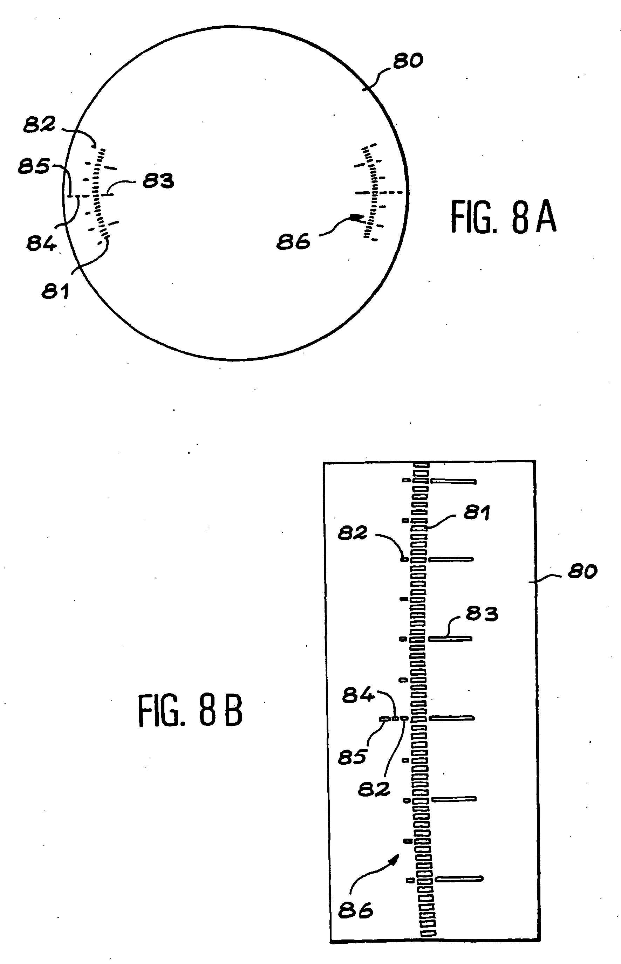

Un autre exemple du procédé selon l'invention est partiellement illustré aux figures 8. On part d'une plaque initiale 80 de silicium cristallin d'environ 10 centimètres de diamètre dont la normale à la surface possède un angle d'inclinaison de plus ou moins un degré dans la direction <001>. On oxyde thermiquement cette plaque initiale 80 sur une épaisseur d'environ 400 nanomètres. Cette plaque initiale 80 est implantée ioniquement par de l'hydrogène à une énergie de 76 keV et une dose de 6.10¹⁶ at/cm².

On réalise ensuite des marques de repérage. Elles prennent ici la forme d'un ou plusieurs ensembles de graduations 86. Les graduations d'un ensemble peuvent être regroupées en plusieurs séries à la manière de celles d'une règle ou d'un rapporteur.

On effectue une photolithographie des ensembles de graduations 86 sur la plaque initiale. Dans l'exemple de la figure 8A on a représenté deux ensembles de graduations, chacun d'entre eux s'étend sur un arc de cercle de 20° environ tel un rapporteur. Ils sont diamétralement opposés. La plaque initiale équipée des ensembles de graduations 86 est représentée à la figure 8A tandis que la figure 8B illustre une portion agrandie d'un des ensembles de graduations. Le rayon de chaque ensemble est de l'ordre de 8 centimètres. Chaque ensemble 86 comporte une première série de marques 81 rectangulaires d'environ 10 micromètres par 30 micromètres espacées d'un centième de degré. Une deuxième série de marques 82 placée entre la première série 81 et le bord de la plaque initiale 80 permet de repérer les vingtièmes de degrés. Une troisième série de marques 83 formée de rectangles plus grands, placée entre la première série 81 et le centre de la plaque initiale 80 permet le repérage des dixièmes de degrés. Une quatrième série de marques 84, placée entre le bord de la plaque initiale et la deuxième série de marques 82 permet de repérer les degrés. Les séries de marques de la figure 8A ne sont pas à l'échelle dans un souci de clarté. Une marque 85 permet de repérer le milieu de l'ensemble de graduations 86.

Une gravure ionique, par exemple, connue sous le sigle RIE pour la dénomination anglo-saxonne de Reactive Ionic Etching permet de graver les marques de repérage 81, 82, 83, 84, 85 dans l'oxyde de surface et le silicium de la plaque initiale jusqu'à une épaisseur d'environ 1150 nanomètres. Cette épaisseur est avantageusement adaptée à l'épaisseur d'oxyde et aux conditions d'implantation.

La plaque initiale est ensuite assemblée par adhésion moléculaire sur une autre plaque de silicium qui sert de poignée et de raidisseur et une séparation est effectuée au niveau de la zone où les ions d'hydrogène se sont implantés, comme décrit dans le brevet FR-A-2 681 472 déjà cité..

La face séparée de la plaque initiale est oxydée et la couronne qui apparaît lors de la découpe est enlevée soit par réduction de diamètre de la plaque soit par abrasion ionique.

La plaque de silicium sur laquelle est collé le film obtenu par la séparation subit une stabilisation du collage au moyen d'un recuit thermique à une température supérieure à environ 600°C puis une oxydation sacrificielle d'environ 100 nanomètres sur la face découpée. Les faces découpées de la plaque initiale et de l'autre plaque sont ensuite désoxydées et polies, par exemple mécanochimiquement ou par un recuit thermique lissant, par exemple avec de l'hydrogène, sur environ 100 nanomètres d'épaisseur pour retrouver une qualité de surface comparable à celle possédée par les plaques de silicium disponibles dans le commerce, soit une rugosité inférieure à environ 0,2 nanomètres rms.

Ces opérations modifient l'angle d'inclinaison de chacune des faces des plaques au maximum d'environ 2.10⁻⁴ degré.

Les faces polies des deux plaques sont ensuite assemblées l'une à l'autre par adhésion moléculaire hydrophobe en contrôlant lors de l'assemblage, leur angle de décalage en rotation θ, par infrarouge, sous microscope, grâce aux ensembles de graduations.

Pour un angle de décalage en rotation θ inférieur au degré, l'angle d'inclinaison résultant α ne dépasse pas 2% de l'angle d'inclinaison de la plaque initiale. Si l'angle d'inclinaison de la plaque initiale vaut 0,5 degré, l'angle d'inclinaison résultant α est inférieur à 9 millièmes de degré alors que si l'angle d'inclinaison de la plaque initiale vaut 0,3 degré, l'angle d'inclinaison résultant α est inférieur à 3 millièmes de degré.

En revanche, si l'angle de décalage en rotation θ croit jusqu'à 180 degrés, l'angle d'inclinaison résultant α croit jusqu'à atteindre une valeur environ égale à deux fois l'angle d'inclinaison de la plaque initiale.

Avantageusement un angle de décalage en rotation de 180° permettra, dans le cas de matériaux cristallins à symétrie d'ordre supérieure ou égale à deux, d'utiliser un comportement de type '0°' de rotation.

## Revendications

1. Procédé de réalisation d'une structure empilée à partir de structures (30, 40) à assembler pour former l'empilement, ces structures (30, 40) comportant chacune au moins une partie cristalline (3,4), comportant au moins les étapes suivantes :
- obtention d'au moins deux parties cristallines (3, 4) par prélèvement dans une même structure initiale (1), chaque partie cristalline (3, 4) prélevée présentant une face (8, 9) créée par le prélèvement, chaque face créée (8,9) présentant un angle d'inclinaison (α1, α2) avec un plan cristallin de référence (p) de la structure initiale (1), la différence entre les angles d'inclinaison des deux faces créées (8, 9) étant déterminée,
- formation des structures (30, 40) à assembler à partir des dites parties cristallines (3, 4), ces structures possédant chacune une face à assembler,
- assemblage des structures (30, 40) par leur face à assembler en repérant les positions relatives des structures (30, 40), en rotation dans le plan de l'interface, par rapport aux positions relatives des parties cristallines (3, 4) respectives au sein de la structure initiale,
**caractérisé en ce que,** lors de la formation des structures (30, 40), les faces à assembler (8, 9) possèdent chacune un angle d'inclinaison maîtrisé par rapport à l'angle d'inclinaison de la face créée (8, 9) de la partie cristalline (3, 4) correspondante, et en jouant, pendant l'assemblage sur l'angle de décalage en rotation des structures à assembler, un angle d'inclinaison résultant volontairement ajusté à l'interface entre les structures (30, 40) est obtenu.

2. Procédé selon la revendication 1, **caractérisé en ce que** la différence entre les angles d'inclinaison (α1, α2) des deux faces créées (8, 9) des deux parties cristallines (3, 4) est nulle ou quasi nulle.

3. Procédé selon l'une des revendications 1 ou 2, **caractérisé en ce que** la structure (30) à assembler est formée en associant la partie cristalline (3) à un support (5), cette association se faisant avant ou après le prélèvement.

4. Procédé selon l'une des revendications 1 à 3, **caractérisé en ce que** la structure (30) à assembler est formée à partir d'une partie cristalline (3) recouverte d'une couche (11) non cristalline.

5. Procédé selon l'une des revendications 1 à 4, **caractérisé en ce que** la partie cristalline (4) prélevée comporte un ou plusieurs matériaux cristallins empilés éventuellement associés à un ou plusieurs matériaux (22) non cristallins.

6. Procédé selon la revendication 1, **caractérisé en ce que,** lorsqu'une structure (30) à assembler est réalisée entièrement dans un matériau cristallin, sa formation se fait en même temps que l'obtention de la partie cristalline (3) associée.

7. Procédé selon l'une des revendications 1 à 6, **caractérisé en ce qu'**il comporte, avant l'assemblage et après le prélèvement, au moins une étape de préparation de la face (8, 9) à assembler d'au moins une des structures (30, 40), cette étape de préparation se faisant en contrôlant l'évolution de l'angle d'inclinaison de la dite face (8, 9).

8. Procédé selon la revendication 7, **caractérisé** l'étape de préparation est un polissage ou un lissage thermique de la face (8, 9) à assembler.

9. Procédé selon l'une des revendications 7 ou 8, **caractérisé en ce que** l'étape de préparation est un amincissement de la structure (40) de manière à mettre à jour un matériau cristallin de la partie cristalline (4).

10. Procédé selon l'une des revendications 7 à 9, **caractérisé en ce que** l'étape de préparation est un amincissement de la structure (40) jusqu'à une couche d'arrêt (17) incluse dans la structure (40) à assembler.

11. Procédé selon l'une des revendications 7 à 10, **caractérisé en ce que** l'étape de préparation est une étape de dépôt ou de croissance d'un matériau (11) sur la face (8) à assembler.

12. Procédé selon l'une des revendications 1 à 11, **caractérisé en ce qu'**il comporte, avant le prélèvement d'au moins une des parties cristallines (3, 4), une étape de fixation de la partie cristalline (3, 4) à assembler sur une première poignée (5, 6).

13. Procédé selon la revendication 12, **caractérisé en ce qu'**il comporte une étape de fixation de la partie cristalline (4) sur une seconde poignée (12) après son prélèvement de la structure initiale (1), puis une étape de retrait de la première poignée (6) libérant la face (13) à assembler.

14. Procédé selon l'une des revendications 1 à 13, **caractérisé en ce qu'**il comporte une étape d'implantation ionique dans l'une au moins des structures (30, 40).

15. Procédé selon l'une des revendications 1 à 14, **caractérisé en ce que** le prélèvement est réalisé par des moyens mécaniques, optiques, chimiques, thermiques, ces moyens étant pris seuls ou en combinaison.

16. Procédé selon l'une des revendications 1 à 15, **caractérisé en ce que** le prélèvement est réalisé par une étape d'implantation ionique au travers d'une face (2) de la structure initiale (1) pour obtenir une zone fragilisée (10), puis par traitement apte à provoquer la séparation de la partie cristalline (3) au niveau de la zone fragilisée (10).

17. Procédé selon l'une des revendications 1 à 16, **caractérisé en ce que** l'étape d'assemblage se fait avec apport de matière.

18. Procédé selon l'une des revendications 1 à 16, **caractérisé en ce que** l'étape d'assemblage se fait par adhésion moléculaire.

19. Procédé selon l'une des revendications 17 ou 18, **caractérisé en ce que** l'étape d'assemblage se termine par un traitement thermique de manière à favoriser des liaisons interatomiques à l'interface.

20. Procédé selon l'une des revendications 1 à 19, **caractérisé en ce que** le répérage des positions relatives des structures (30, 40) lors de l'assemblage comporte une étape de repérage d'au moins un axe cristallin d'au moins une des parties cristallines (3, 4).

21. Procédé selon l'une des revendications 1 à 19, **caractérisé en ce que** le répérage des positions relatives des structures (30, 40) lors de l'assemblage est réalisé à l'aide d'une ou plusieurs marques de repérage (18, 19, 20, 92) portées par la structure initiale (1) et se retrouvant sur les parties cristallines (3, 4) après prélèvement.

22. Procédé selon la revendication 21, **caractérisé en ce que** les marques de repérage sont formées par un ou plusieurs ensembles (86) de graduations.

23. Procédé selon l'une des revendications 21 ou 22, **caractérisé en ce qu'**il comporte une étape de report des marques de repérage (96.1, 96.2) sur d'autres parties de la structure initiale (1) et/ou des structures (30, 40) à assembler.

24. Procédé selon l'une des revendications 21 à 23, **caractérisé en ce que** les marques de repérage sont réalisées au moyen d'au moins une technique choisie parmi la gravure chimique, la gravure ionique, la gravure optique, la gravure mécanique.

25. Procédé selon la revendication 21, **caractérisé en ce que** la marque de repérage est un méplat (20).

26. Procédé selon l'une des revendications 21 à 25, **caractérisé en ce que** le répérage des positions relatives des structures (30, 40) lors de l'assemblage est réalisé en ajustant, la position d'au moins une marque de repérage (92.1) de l'une des structures (30) à assembler par rapport à la position d'au moins une marque de repérage (92.2) d'une autre structure (40) à assembler, par des moyens choisis parmi les moyens optiques, mécaniques, acoustiques, hydrodynamiques ces moyens étant pris seuls ou en combinaison.

27. Procédé selon l'une des revendications 1 à 26, **caractérisé en ce qu'**il consiste à séparer en deux parties la structure initiale (1), chacune d'entre elles conduisant à une des structures (30, 40) à assembler.

28. Procédé selon l'une des revendications 1 à 26, **caractérisé en ce que** plusieurs séparations dans la structure initiale (1) conduisent à l'obtention des structures à assembler (30, 40).

29. Procédé selon l'une des revendications précédentes dans lequel les parties cristallines (3, 4) sont réalisées à base de matériaux semi-conducteurs, supraconducteurs, diélectriques, magnétiques, métalliques, ces matériaux étant pris seuls, combinés, mélangés.

## Claims

1. Method for producing a stacked structure from structures (30, 40) to be assembled to form the stack, said structures (30, 40) each comprising at least one crystalline part (3, 4), comprising at least the following steps:
- obtaining at least two crystalline parts (3, 4) by detaching them from a same initial structure (1), each detached crystalline part (3, 4) having one face (8, 9) created by the detachment, each created face having a tilt angle (α1, α2) with a reference crystalline plane (p) of the initial structure (1), the difference between the tilt angles of the two created faces (8, 9) being determined,
- forming structures (30, 40) to be assembled from said crystalline parts (3, 4), said structures (30, 40) each having a face to be assembled (8, 9),
- assembling said structures (30, 40) by their face to be assembled while controlling the relative positions of said structures (30, 40), rotating in the interface plane, in relation to the relative positions of the respective crystalline parts (3, 4) within the initial structure, **characterized in that** during the step of structures forming, the faces to be assembled have each a controlled tilt angle in relation to the tilt angle of the created face (8, 9) of the corresponding crystalline part (3, 4), and by playing on, during the assembly, the twist angle of the structures to be assembled, a resulting tilt angle adjusted at will is obtained.

2. Method according to claim 1, **characterised in that** the difference between the tilt angles (α1, α2) of the two created faces (8, 9) of the two crystalline parts (3, 4) is zero or almost zero.

3. Method according to claim 1 or 2, **characterised in that** the structure (30) to be assembled is formed by combining the crystalline part (3) with a support (5), said combination being carried out before or after the detachment.

4. Method according to one of claims 1 to 3, **characterised in that** the structure (30) to be assembled is formed from a crystalline part (3) covered with a non-crystalline layer (11).

5. Method according to one of claims 1 to 4, **characterised in that** the detached crystalline part (4) comprises one or several stacked crystalline materials eventually combined with one or several non-crystalline materials (22).

6. Method according to claim 1, **characterised in that,** when a structure (30) to be assembled is formed entirely of a crystalline material, its formation is carried out at the same time as the combined crystalline part (3) is obtained.

7. Method according to one of claims 1 to 6, **characterised in that** it comprises, before the assembly and after the detachment, at least one step of preparing the face (8, 9) to be assembled of at least one of the structures (30, 40), said preparation step being carried out while controlling the change in the tilt angle of said face (8, 9).

8. Method according to claim 7, **characterised in that** the preparation step is a polishing or a thermal smoothing of the face (8, 9) to be assembled.

9. Method according to claim 7 or 8, **characterised in that** the preparation step is a thinning down of the structure (40) in such a way as to expose a crystalline material of the crystalline part (4).

10. Method according to one of claims 7 to 9, **characterised in that** the preparation step is a thinning down of the structure (40) down to a stop layer (17) included in the structure (40) to be assembled.

11. Method according to one of claims 7 to 10, **characterised in that** the preparation step is a step of depositing or building up a material (11) on the face (8) to be assembled.

12. Method according to one of claims 1 to 11, **characterised in that** it comprises, before the detachment of at least one of the crystalline parts (3, 4), a step of attaching the crystalline part (3, 4) to be assembled onto a first grip (5, 6).

13. Method according to claim 12, **characterised in that** it comprises a step of attaching the crystalline part (4) on a second grip (12) after its detachment from the initial structure (1), then a step of removing the first grip (6), freeing the face (13) to be assembled.

14. Method according to one of claims 1 to 13, **characterised in that** it comprises a step of ion implantation in at least one of the structures (30, 40).

15. Method according to one of claims 1 to 14, **characterised in that** the detachment is carried out by mechanical, optical, chemical or thermal means, said means being used alone or in combination.

16. Method according to one of claims 1 to 15, **characterised in that** the detachment is carried out by a step of ion implantation through a face (2) of the initial structure (1) in order to obtain an embrittled zone (10), then by suitable treatment capable of leading to the separation of the crystalline part (3) at the level of the embrittled zone (10).

17. Method according to one of claims 1 to 16, **characterised in that** the assembly step is carried out with input of material.

18. Method according to one of claims 1 to 16, **characterised in that** the assembly step is carried out by molecular adhesion.

19. Method according to claim 17 or 18, **characterised in that** the assembly step ends with a thermal treatment in such a way as to favour interatomic bonds at the interface.

20. Method according to one of claims 1 to 19, **characterised in that** the control of the relative positions of the structures (30, 40) during the assembly comprises a step of marking at least one crystalline axis of at least one of the crystalline parts (3, 4).

21. Method according to one of claims 1 to 19, **characterised in that** the control of the relative positions of the structures (30, 40) during the assembly is achieved by means of one or several set marks (18, 19, 20, 92) borne on the initial structure (1) and refound on the crystalline parts (3, 4) after detachment.

22. Method according to claim 21, **characterised in that** the set marks are formed by one or several series (86) of graduations.

23. Method according to claim 21 or 22, **characterised in that** it comprises a step of carrying over the set marks (96.1, 96.2) onto the other parts of the initial structure (1) and/or structures (30, 40) to be assembled.

24. Method according to one of claims 21 to 23, **characterised in that** the set marks are formed by means of at least one technique chosen from among chemical etching, ion beam etching, optical engraving or mechanical engraving.

25. Method according to claim 21, **characterised in that** the set mark is a reference flat (20).

26. Method according to one of claims 21 to 25, **characterised in that** the control of the relative positions of the structures (30, 40) during the assembly is carried out by adjusting the position of at least one set mark (92.1) of one of the structures (30) to be assembled in relation to the position of at least one set mark (92.2) of another structure (40) to be assembled, by means chosen from among optical, mechanical, acoustical, hydrodynamic means, said means being used alone or in combination.

27. Method according to one of claims 1 to 26, **characterised in that** it consists in separating into two parts the initial structure (1), each of said parts leading to one of the structures (30, 40) to be assembled.

28. Method according to one of claims 1 to 26, **characterised in that** several separations in the initial structure (1) lead to structures to be assembled (30, 40) being obtained.

29. Method according to one of the preceding claims wherein the crystalline parts are made from semi-conductor, superconductor, dielectric, magnetic, metallic materials, said materials being used alone, combined or mixed.

## Patentansprüche

1. Verfahren zur Herstellung einer Stapelstruktur aus zum Bilden des Stapels zusammenzusetzenden Strukturen (30, 40), wobei jede dieser Strukturen (30, 40) wenigstens einen kristallinen Teil (3, 4) einschließt, umfassend wenigstens die folgenden Schritte:
- Erhalten wenigstens zweier kristalliner Teile (3, 4) durch Entfernen bei derselben Ausgangsstruktur (1), wobei jeder entfernte kristalline Teil (3, 4) eine durch das Entfernen geschaffene Fläche (8, 9) aufweist, jede geschaffene Fläche (8, 9) einen Neigungswinkel (α1, α2) mit einer Bezugskristallebene (p) der Ausgangsstruktur (1) aufweist und wobei die Differenz zwischen den Neigungswinkeln der beiden geschaffenen Flächen (8, 9) bestimmt wird,
- Bilden der zusammenzufügenden Strukturen (30, 40) aus den besagten kristallinen Teilen (3, 4), wobei jede dieser Strukturen eine zusammenzufügende Fläche besitzt,
- Zusammenfügen der Strukturen (30, 40) über ihre zusammenzufügende Fläche unter Kontrollieren der relativen Positionen der Strukturen (30, 40) unter Drehen in der Grenzflächenebene bezüglich der relativen Positionen der jeweiligen kristallinen Teile (3, 4) innerhalb der Ausgangsstruktur,
**dadurch gekennzeichnet, dass** bei der Bildung der Strukturen (30, 40) jede der zusammenzufügenden Flächen (8, 9) einen Neigungswinkel besitzt, der bezüglich des Neigungswinkels der geschaffenen Fläche (8, 9) des entsprechenden kristallinen Teils (3, 4) kontrolliert wird, und dass während des Zusammensetzens durch Variieren des Verschiebungswinkels durch Drehung der zusammenzusetzenden Strukturen (30, 40) ein gezielt eingestellter, sich daraus ergebender Neigungswinkel an der Grenzfläche zwischen den Strukturen (30, 40) erhalten wird.

2. Verfahren gemäß Anspruch 1, **dadurch gekennzeichnet, dass** die Differenz zwischen den Neigungswinkeln (α1, α2) der beiden geschaffenen Flächen (8, 9) der beiden kristallinen Teile (3, 4) null oder beinahe null ist.

3. Verfahren gemäß einem der Ansprüche 1 oder 2, **dadurch gekennzeichnet, dass** die zusammenzufügende Struktur (30) durch Zusammenfügen des kristallinen Teils (3) mit einem Träger (5) gebildet wird, wobei dieses Zusammenfügen vor oder nach dem Entfernen durchgeführt wird.

4. Verfahren gemäß einem der Ansprüche 1 bis 3, **dadurch gekennzeichnet, dass** die zusammenzufügende Struktur (30) aus einem kristallinen Teil (3) gebildet wird, der mit einer nichtkristallinen Schicht (11) beschichtet ist.

5. Verfahren gemäß einem der Ansprüche 1 bis 4, **dadurch gekennzeichnet, dass** der entfernte kristalline Teil (4) eine oder mehrere kristalline, gestapelte Materialien umfasst, die gegebenenfalls mit einem oder mehreren nichtkristallinen Materialien (22) verbunden sind.

6. Verfahren gemäß Anspruch 1, **dadurch gekennzeichnet, dass** wenn eine zusammenzufügende Struktur (30) vollständig aus einem kristallinen Material hergestellt ist, ihre Bildung gleichzeitig mit dem Erhalten des damit verbundenen Teils (3) ausgeführt wird.

7. Verfahren gemäß einem der Ansprüche 1 bis 6, **dadurch gekennzeichnet, dass** es vor dem Zusammenfügen und nach dem Entfernen wenigstens einen Schritt der Vorbereitung der zusammenzufügenden Fläche (8, 9) wenigstens einer der Strukturen (30, 40) umfasst, wobei dieser Vorbereitungsschritt durch Kontrollieren der Änderung des Neigungswinkels der besagten Fläche (8, 9) ausgeführt wird.

8. Verfahren gemäß Anspruch 7, **dadurch gekennzeichnet, dass** der Vorbereitungsschritt ein Polieren oder thermisches Glätten der zusammenzufügenden Fläche (8, 9) ist.

9. Verfahren gemäß einem der Ansprüche 7 oder 8, **dadurch gekennzeichnet, dass** der Vorbereitungsschritt ein Ausdünnen der Struktur (40) unter Freilegen eines kristallinen Materials des kristallinen Teils (4) ist.

10. Verfahren gemäß einem der Ansprüche 7 bis 9, **dadurch gekennzeichnet, dass** der Vorbereitungsschritt ein Ausdünnen der Struktur (40) bis zu einer in der zusammenzufügenden Struktur (40) enthaltenen Stoppschicht (17) ist.

11. Verfahren gemäß einem der Ansprüche 7 bis 10, **dadurch gekennzeichnet, dass** der Vorbereitungsschritt ein Schritt der Beschichtung oder des Aufwachsens eines Materials (11) auf der zusammenzufügenden Fläche (8) ist.

12. Verfahren gemäß einem der Ansprüche 1 bis 11, **dadurch gekennzeichnet, dass** es vor dem Entfernen wenigstens eines der kristallinen Teile (3, 4) einen Schritt des Befestigens des zusammenzufügenden kristallinen Teils (3, 4) auf einem Haltegriff umfasst.

13. Verfahren gemäß Anspruch 12, **dadurch gekennzeichnet, dass** es einen Schritt des Befestigens des kristallinen Teils (4) auf einem zweiten Haltegriff (12) nach seinem Entfernen von der Anfangsstruktur (1) und dann einen Schritt des Entfernens des ersten Haltegriffs (6) umfasst, wobei die zusammensetzende Fläche (13) freigesetzt wird.

14. Verfahren gemäß einem der Ansprüche 1 bis 13, **dadurch gekennzeichnet, dass** es einen Schritt der Ionenimplantation in wenigstens eine der Strukturen (30, 40) umfasst.

15. Verfahren gemäß einem der Ansprüche 1 bis 14, **dadurch gekennzeichnet, dass** das Entfernen durch mechanische, optische, chemische oder thermische Mittel durchgeführt wird, wobei diese Mittel einzeln oder in Kombination verwendet werden.

16. Verfahren gemäß einem der Ansprüche 1 bis 15, **dadurch gekennzeichnet, dass** das Entfernen durch einen Schritt der lonenimplantation durch eine Fläche (2) der Ausgangsstruktur (1) unter Erhalten eines versprödeten Bereichs (10) und dann durch eine geeignete Behandlung durchgeführt wird, die die Trennung des kristallinen Teils (3) in Höhe der versprödeten Zone (10) bewirken kann.

17. Verfahren gemäß einem der Ansprüche 1 bis 16 **dadurch gekennzeichnet, dass** der Schritt des Zusammenfügens unter Materialzufuhr durchgeführt wird.

18. Verfahren gemäß einem der Ansprüche 1 bis 16 **dadurch gekennzeichnet, dass** der Schritt des Zusammenfügens durch molekulare Adhäsion durchgeführt wird.

19. Verfahren gemäß einem der Ansprüche 17 oder 18, **dadurch gekennzeichnet, dass** der Schritt des Zusammenfügens durch eine Wärmebehandlung unter Fördern zwischenatomarer Bindungen an der Oberfläche durchgeführt wird.

20. Verfahren gemäß einem der Ansprüche 1 bis 19, **dadurch gekennzeichnet, dass** das Markieren der relativen Positionen der Strukturen (30, 40) bei dem Zusammenfügen einen Schritt des Markierens wenigstens einer Kristallachse wenigstens eines der kristallinen Teile (3, 4) umfasst.

21. Verfahren gemäß einem der Ansprüche 1 bis 19, **dadurch gekennzeichnet, dass** das Markieren der relativen Positionen bezüglich der Strukturen (30, 40) bei dem Zusammenfügen mittels einer oder mehrerer, von der Ausgangsstruktur (1) getragener Markierungszeichen (18, 19, 20, 92), die sich nach dem Entfernen auf den kristallinen Teilen (3,4) wiederfinden, durchgeführt wird.

22. Verfahren gemäß Anspruch 21, **dadurch gekennzeichnet, dass** die Markierungszeichen durch eine oder mehrere Reihen von Teilstrichen (86) gebildet werden.

23. Verfahren gemäß einem der Ansprüche 21 oder 22, **dadurch gekennzeichnet, dass** es einen Schritt des Übertragens der Markierungszeichen (96.1, 96.2) auf andere Teile der Ausgangsstruktur (1) und/oder der zusammenzusetzenden Strukturen (30, 40) umfasst.

24. Verfahren gemäß einem der Ansprüche 21 bis 23, **dadurch gekennzeichnet, dass** die Markierungszeichen mittels wenigstens einer Technik hergestellt werden, die aus dem chemischen Ätzen, dem lonenätzen, dem optischen Ätzen und dem mechanischen Ätzen ausgewählt ist.

25. Verfahren gemäß Anspruch 21, **dadurch gekennzeichnet, dass** das Markierungszeichen eine Abflachung (20) ist.

26. Verfahren gemäß einem der Ansprüche 21 bis 25, **dadurch gekennzeichnet, dass** das Markieren der relativen Positionen der Strukturen (30, 40) bei dem Zusammenfügen durch Einstellen der Position wenigstens eines Markierungszeichens (92.1) einer der zusammenzufügenden Strukturen (30) bezüglich der Position wenigstens eines Markierungszeichens (92.2) einer anderen zusammenzufügenden Struktur (40) durch Mittel ausgeführt wird, die aus optischen, mechanischen, akustischen und hydrodynamischen Mitteln ausgewählt sind, wobei diese Mittel einzeln oder in Kombination verwendet werden.

27. Verfahren gemäß einem der Ansprüche 1 bis 26, **dadurch gekennzeichnet, dass** es aus dem Trennen der Ausgangsstruktur (1) in zwei Teile besteht, wobei jeder davon zu einer der zusammenzufügenden Strukturen (30, 40) führt.

28. Verfahren gemäß einem der Ansprüche 1 bis 26, **dadurch gekennzeichnet, dass** mehrere Trennungen bei der Ausgangsstruktur (1) zum Erhalt der zusammenzufügenden Strukturen (30, 40) führen.

29. Verfahren gemäß einem der vorangehenden Ansprüche, bei dem die kristallinen Teile (3, 4) auf der Grundlage von Halbleiter-, Supraleiter-, dielektrischen, magnetischen oder metallischen Materialien hergestellt werden, wobei diese Materialien einzeln, kombiniert oder gemischt verwendet werden.
